# DEMANDE DE BREVET EUROPEEN

(11) **EP 0 703 609 A1**
(43) Date de publication de la demande: **27.03.1996**
(21) Numéro de dépôt: 95402122.6
(22) Date de dépôt: 20.09.1995
(51) Int. Cl.: H01L 21/762, H01L 21/20

(54) **Procédé de fabrication d'une structure comportant une couche mince semi-conductrice sur un substrat**

(30) Priorité: 22.09.1994 FR 9411311
(71) Demandeur: COMMISSARIAT A L'ENERGIE ATOMIQUE, F-75015 Paris Cédex 15 (FR)
(72) Inventeur: Bruel, Michel, F-38113 Veurey (FR); Poumeyrol, Thierry, F-38360 Noyarey (FR)
(74) Mandataire: Dubois-Chabert, Guy

(57) **Abrégé**

Procédé de fabrication d'une structure comportant une couche mince (4) semi-conductrice adhérente sur un substrat cible (24) . Le procédé comporte les étapes suivantes :
a) - fabrication d'une première structure comportant une couche mince (4) semi-conductrice sur un premier substrat,
b) - transfert de la couche mince (4) du premier substrat sur le substrat (24) dit substrat cible.

Application à la fabrication de composants électroniques.

## Description

### Domaine technique

La présente invention concerne un procédé de fabrication d'une structure comportant une couche mince semi-conductrice sur un substrat de coefficient de dilatation identique ou différent de celui de la couche. L'invention s'applique notamment dans les domaines de la microélectronique et en particulier pour réaliser des structures avec une couche mince de silicium monocristallin sur un substrat de quartz ou de verre.

De telles structures sont utilisées par exemple pour la fabrication d'écran plats à matrice active.

### Etat de la technique antérieure

Lors d'un report d'une couche mince sur un substrat d'une autre nature que la couche mince, se pose généralement le problème d'une dilatation différentielle due à des coefficients de dilatation différents. Un exemple qui illustre particulièrement bien ce problème est celui du report d'une couche de silicium monocristallin sur un substrat de verre ou de quartz. Le coefficient de dilatation du silicium est de l'ordre de 2,6 à 2,8 ppm (parties par million) par degré celsius, tandis que celui du quartz est de 0,2 à 0,5ppm/°C. Pour le verre, le coefficient de dilatation qui est fonction notamment de sa composition est compris entre celui du silicium et celui du quartz.

La différence de dilatation entre la couche et le substrat entraîne des contraintes mécaniques importantes.

Les procédés connus de report d'une couche mince, par exemple d'une couche de silicium monocristallin sur un substrat de quartz comportent généralement les étapes suivantes :
- mise en contact adhérent, à température ambiante d'une plaquette de silicium monocristallin sur substrat de quartz. Cette mise en contact comporte des opérations de nettoyage et de préparation des surfaces par traitements chimiques préalablement à la mise en contact des surfaces.
- traitement thermique à faible température entre 50°C et 70°C pour augmenter l'énergie de liaison sans générer de contraintes de dilatation différentielle trop grandes qui pourraient conduire à la fracture du substrat ou de la plaquette, ou à un décollement,
- abrasion mécanique, mécano chimique ou chimique de la plaquette de silicium de façon à ne laisser qu'une épaisseur de couche de silicium de quelques micromètres à quelques dizaines de micromètres.
- traitement thermique à température un peu plus élevée 100°C (pour augmenter l'adhérence de la couche). Comme la couche de silicium a été amincie, les contraintes exercées au niveau de l'interface silicium-quartz sont plus faibles lors de ce traitement.
- finition de la couche par polissage mécano chimique ou chimique pour atteindre l'épaisseur désirée,
- traitement thermique haute température (600°C par exemple) pour parachever la liaison silicium-quartz.

Le plus souvent, une succession de plusieurs étapes d'abrasion et de traitement thermique est nécessaire. Les étapes d'abrasion permettent d'amincir progressivement la plaquette. Les traitements thermiques augmentent l'énergie de liaison entre la couche et le substrat mais génèrent des tensions mécaniques en raison des dilatations différentes de la couche et du substrat. L'abrasion permet par l'amincissement de la couche mince, d'augmenter sa tenue à la dilatation différentielle.

Les nombreuses étapes successives, notamment de traitements abrasif et thermique rendent ces procédés de transfert très complexes et coûteux. De plus, ces traitements peuvent altérer la qualité de la couche mince finalement obtenue.

Par ailleurs, même lorsque le substrat et la couche mince ont un coefficient de dilatation identique, la formation de la couche mince directement sur le substrat peut poser également des problèmes et nécessiter d'utiliser une technique de report. C'est par exemple le cas, lorsque la température de réalisation de la couche mince est supérieure à la température admissible par le substrat.

Un but de la présente invention est de fournir un procédé de transfert qui ne présente pas la complexité des techniques connues et qui permet d'obtenir un report d'une couche mince d'excellente qualité.

### Exposé de l'invention

Pour éviter ces difficultés, l'invention se rapporte plus précisément à un procédé de fabrication d'une structure comportant une couche mince semi-conductrice adhérente sur un substrat cible, caractérisé en ce qu'il comporte les étapes suivantes :
a) - fabrication d'une première structure comportant une couche mince semi-conductrice sur un premier substrat, la couche mince présentant une première face libre dite face avant et une seconde face dite face arrière liée au premier substrat par une première énergie de liaison Eₒ,
b) - transfert de la couche mince du premier substrat sur le substrat cible, ce transfert comportant à la fois un arrachement de la couche mince du premier substrat par l'application sur l'ensemble couche mince/premier substrat de forces d'arrachement aptes à vaincre la première énergie de liaison et une mise en contact adhérent de la couche mince sur le substrat cible.

Selon un aspect de l'invention, l'étape b) du procédé comporte :
b₁) - la mise en contact adhérent d'un manipulateur avec la première face de la couche mince, le contact adhérent étant établi avec une seconde énergie de liaison E₁ supérieure à la première énergie de liaison,
b₂) - séparation de la couche mince et du premier substrat par l'arrachement de la couche mince au niveau de la seconde face et du premier substrat,
b₃) - mise en contact adhérent de la seconde face de la couche mince sur le substrat cible avec une troisième énergie de liaison E₂, et séparation de la couche mince du manipulateur.

On entend par manipulateur un support tel qu'un substrat qui permet de maintenir la couche mince notamment pendant sa séparation du premier substrat. Ce support sert de prise mécanique pour la préhension de la couche mince et pour exercer des forces d'arrachement.

Lorsque la séparation de la couche mince, du manipulateur est obtenue par des forces d'arrachement appliquées sur l'ensemble couche mince/manipulateur, la troisième énergie de liaison E₂ est supérieure à la seconde énergie de liaison E₁.

Selon une autre variante de l'invention, l'étape b) du procédé comporte successivement la mise en contact adhérent directement de la première face de la couche mince sur le substrat cible avec une énergie de liaison supérieure à la première énergie de liaison puis l'arrachement de la couche mince, du premier substrat.

Grâce à l'invention, la couche mince peut être réalisée directement sur le premier substrat, c'est-à-dire sur un substrat qui présente un coefficient de dilatation soit identique, soit très voisin de celui de la couche mince. Cette réalisation peut avoir lieu par exemple par des traitements connus de mise en contact par exemple par collage de plaquettes et d'abrasion mécanique ou mécano-chimique. Les problèmes de dilatation différentielle n'existant pas dans ce cas, les traitements pour amincir la couche mince sont largement facilités.

Selon un autre mode de réalisation, la couche mince peut être obtenue par une implantation d'ions de gaz rare ou d'hydrogène dans un substrat supplémentaire, à travers sa surface. L'implantation génère une couche de microbulles gazeuses s'étendant sensiblement selon un plan qui délimite dans le substrat supplémentaire une couche mince superficielle. La profondeur de l'implantation des ions permet de régler l'épaisseur de la couche mince. Le premier substrat selon l'invention est alors mis en contact adhérent (avec la première énergie de liaison) avec la couche mince. Puis, on effectue un traitement thermique qui par un effet de réarrangement cristallin et par un effet de pression dans les microbulles gazeuses provoque un clivage, c'est-à-dire la séparation de la couche mince du reste du substrat supplémentaire.

Après la fourniture du premier substrat avec la couche mince, la face libre de la couche, est mise en contact adhérent soit directement avec le substrat cible, soit avec un manipulateur.

Le manipulateur peut être par exemple un film ou une feuille souple en matériau organique tel que, par exemple, le polychlorure de vinyle. On peut aussi utiliser un film en aluminium.

Le contact adhérent selon le procédé de l'invention peut avoir lieu par des moyens de traitement thermique et/ou de pression et/ou de préparation chimique des surfaces à mettre en contact. Il est possible également, dans le cas particulier du contact adhérent entre la couche et le manipulateur, d'utiliser un adhésif, par exemple un adhésif de type acrylique ou de type époxy dont on enduit le manipulateur.

Il est important que l'énergie de liaison entre le manipulateur et la couche mince soit supérieure à l'énergie de liaison entre la couche mince et le premier substrat.

Une autre possibilité pour réaliser le contact adhérent particulier entre le manipulateur et la couche mince consiste en la mise en oeuvre de forces électrostatiques entre ces deux parties. Un champ électrique est établi entre la couche mince semi-conductrice et le manipulateur. Le manipulateur comporte dans ce cas ou est lui-même une couche conductrice formant une électrode, celle-ci peut être en un matériau conducteur de l'électricité tel que l'aluminium.

Un film isolant ou une couche isolante sont aussi prévus à la surface de la couche conductrice afin de former le diélectrique d'un condensateur dont les armatures sont la couche conductrice et la couche mince. L'application d'une tension entre ces deux armatures crée une énergie de liaison entre la couche mince et le manipulateur qui peut être réglée en ajustant la tension électrostatique. Les forces de liaison peuvent aussi être établies ou supprimées par simple application ou suppression de la tension.

Lorsque le manipulateur est fermement lié à la couche mince, c'est-à-dire avec une énergie de liaison E₁ supérieure à l'énergie de liaison Eₒ entre le substrat et la couche mince, l'étape de séparation par arrachement peut avoir lieu.

De façon générale, dans l'invention, l'arrachement peut être réalisé par une force de traction et/ou une force de cisaillement.

On entend par force de traction et de cisaillement, une force résultante. En effet, la force de traction et/ou de cisaillement peut être unique ou se décomposer en une pluralité de forces dont l'action est combinée.

La mise en contact adhérent de la couche mince avec le substrat cible et la séparation de la couche mince du manipulateur peuvent avoir lieu dans un ordre indifférent. La mise en contact de la couche mince avec le substrat cible peut avoir lieu avant ou après la séparation avec le manipulateur.

L'ordre des opérations dépend notamment de la face de la couche mince qui est mise en contact avec le substrat cible. Il est en effet possible, grâce à l'invention, de mettre en contact du substrat cible soit sa face avant soit sa face arrière.

Selon un premier mode de mise en oeuvre de l'invention la face arrière de la couche mince, qui est sa face libre lorsque celui-ci est en contact avec le manipulateur, est mise en contact adhérent avec une face du substrat cible. Cette adhérence est obtenue également de manière connue par l'usage d'adhésif ou par des traitements de surface et/ou des traitements thermiques et/ou de pression ou encore par l'utilisation de forces électrostatiques.

Le manipulateur est ensuite séparé de la couche mince. La séparation peut avoir lieu sous l'effet de forces d'arrachement, à l'instar de l'opération de séparation de la couche mince du premier substrat. Dans ce cas, il est important que l'énergie de liaison E₂ entre la couche mince et le substrat cible soit supérieure à l'énergie E₁ de liaison entre la couche mince et le manipulateur.

Dans le cas où l'adhérence entre le manipulateur et la couche mince est obtenue par des forces électrostatiques, la séparation a lieu simplement en éliminant la tension électrostatique correspondante.

La séparation de la couche mince et du manipulateur peut aussi être obtenue par dissolution du manipulateur dans un bain chimique.

Selon un autre mode de mise en oeuvre de l'invention, la séparation de la couche mince du manipulateur a lieu avant la mise en contact avec le substrat cible. Dans ce cas, l'ensemble fourni par le manipulateur et la couche mince, est plongé dans un bain chimique apte à dissoudre le manipulateur. Lorsque le manipulateur est en aluminium, le bain peut être de l'acide fluorhydrique. Si le contact est réalisé par de la colle époxy alors la dissolution de la colle a lieu par exemple avec de l'acide nitrique.

Lorsque le manipulateur est dissous, la couche mince flotte à la surface du bain. La couche mince est recueillie sur le substrat cible qui, après avoir été également immergé dans le bain, est remonté vers la surface du bain à l'aide par exemple d'une pince.

Ce mode de mise en oeuvre du procédé permet de recueillir la couche mince sur le substrat cible, en mettant en contact avec ce dernier soit sa face avant soit sa face arrière.

Afin de faciliter le transfert de la couche mince sur le substrat cible, celui-ci peut être choisi de taille supérieure à celle de la couche mince.

D'autres caractéristiques et avantages de l'invention ressortent de la description qui va suivre, en référence aux figures annexées données à titre d'illustration.

### Brève description des figures

- la figure 1 est une coupe schématique d'un premier substrat et d'une couche mince en contact avec ce substrat,
- la figure 2 est une coupe schématique du substrat, de la couche mince et d'un manipulateur mis en contact avec la couche mince,
- la figure 3 est une coupe schématique du manipulateur en contact avec la couche mince qui est séparée du premier substrat,
- la figure 4 est une coupe schématique du manipulateur, de la couche mince et d'un substrat cible sur lequel est reportée la couche mince, le manipulateur étant séparé de la couche mince.

### Exposé détaillé de modes de mise en oeuvre du procédé de l'invention

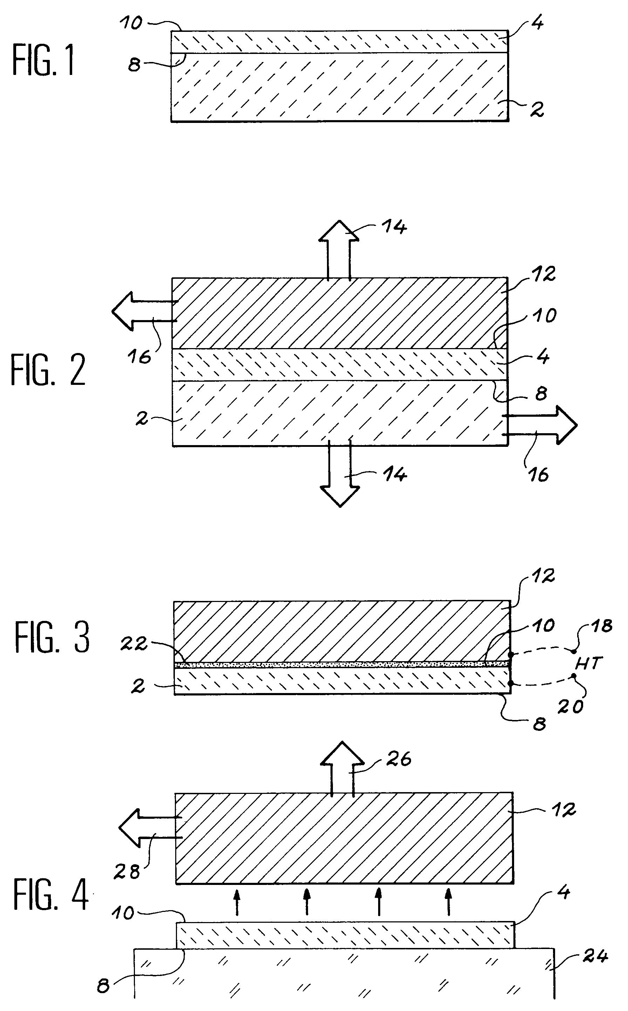

La figure 1 montre la structure de départ qui comporte un premier substrat 2, par exemple en un matériau semi-conducteur, sur lequel est formé une couche mince 4. La couche mince est de préférence de structure monocristalline.

De façon bien connue, la formation de la couche mince peut comporter, par exemple, un collage à température ambiante d'une plaquette de silicium sur le substrat 2, un traitement thermique pour augmenter l'énergie de liaison de la plaquette avec le substrat, puis son amincissement par abrasion. Ces opérations sont de mise en oeuvre simple dans la mesure où la couche mince et le substrat sont soit de même nature, soit présentent des coefficients de dilatation sensiblement les mêmes.

Conformément à l'invention, et selon un mode aussi particulier de mise en oeuvre, la couche mince 4 peut être définie par implantation d'ions de gaz rare ou d'hydrogène à une certaine profondeur dans un substrat supplémentaire. Une telle implantation génère dans le substrat supplémentaire une mince couche de microbulles gazeuses qui délimite la couche mince et constitue un "plan" de clivage pour séparer ultérieurement la couche mince du reste du substrat supplémentaire lorsque la couche mince est contact adhérent avec le premier substrat. Un tel procédé de formation de couches minces est décrit par exemple dans la demande de brevet français n°2681472.

La couche mince comporte donc une face arrière 8, en contact avec le substrat 2 et une face avant libre 10.

Un manipulateur 12, représenté à la figure 2, qui est par exemple une feuille d'aluminium enduit d'une colle de type époxy ou une feuille de polychrorure de vinyle enduit d'un adhésif de type acrylique, est collé sur la face 10 de la couche mince avec une énergie E₁ de liaison supérieure à l'énergie de liaison Eₒ entre la couche mince et le substrat. La face arrière 8 de la couche mince est toujours en contact avec le substrat.

Des forces de traction et/ou de cisaillement représentées respectivement par des flèches 14, 16 sur la figure 2 sont appliquées sur le manipulateur et/ou le substrat. Le substrat peut aussi être simplement maintenu ferme pendant que les forces sont appliquées sur le manipulateur.

Les forces 14, 16 provoquent une séparation de la couche mince et du substrat, la couche mince restant en contact avec le manipulateur 12 comme le montre la figure 3.

La figure 3 montre aussi de façon accessoire et très schématique un autre mode de mise en contact de la couche mince et du manipulateur, mettant en oeuvre des forces électrostatiques. Le manipulateur 12, de préférence en métal est alors relié à une première borne 18 d'un générateur de haute tension. La couche mince 4 est reliée à une autre borne 20 du générateur. Une couche d'isolation 22 est dans ce cas formée à la surface du manipulateur pour l'isoler électriquement de la couche mince. Le manipulateur et la couche mince forment alors respectivement les armatures d'un condensateur et des forces électrostatiques les maintiennent en contact lorsqu'une tension est appliquée entre les bornes 18 et 20.

La figure 4 représente la mise en contact adhérent de la couche mince 4 avec un substrat cible 24, et la séparation de la couche mince 4 et du manipulateur 12. De préférence, le substrat cible 24 présente une taille supérieure à celle du film mince. Par exemple, le substrat cible est une pastille d'un diamètre de 12,5 cm alors que la couche mince présente en l'une de ses surfaces 10 ou 8, une dimension de 10 cm.

Le substrat cible 24, par exemple une plaque de verre ou de quartz, présente un coefficient de dilatation qui peut être différent de celui de la couche mince. En effet, la mise en contact adhérent, par exemple par le traitement chimique des surfaces à mettre en contact, peut avoir lieu à température ambiante et les problèmes de dilatation ne se posent pas. Il est possible aussi de poursuivre cette étape par un traitement thermique pour augmenter l'énergie de liaison. Comme la couche mince 4 a été formée ou amincie avant sa mise en contact avec le substrat cible, le traitement thermique n'entraîne pas de contraintes excessives de dilatation différentielle : comme la couche 4 est fine ses déformations suivent celles du substrat cible 24 sur lequel elle est déposée.

Quand la couche mince 4 adhère sur le substrat cible 24, le manipulateur est séparé par l'exercice de forces de traction et/ou de cisaillement représentées par des flèches 26, 28.

Les forces 26, 28 de même que les forces 14, 16 de la figure 2 peuvent être exercées soit manuellement, soit mécaniquement.

Lors de cette opération, l'énergie de liaison E₂ entre la couche 4 et le substrat 24 doit être supérieure à l'énergie de liaison E₁ entre la couche 4 et le manipulateur 12.

Comme décrit plus haut, le manipulateur peut aussi être séparé de la couche 4 en le faisant dissoudre dans un bain chimique ou lorsque le contact est réalisé par des forces électrostatiques, par coupure de la tension électrostatique.

Par ailleurs, le manipulateur peut aussi être dissous avant de recueillir la couche mince 4 sur le substrat cible. Dans ce cas, la couche mince 4 peut être mise en contact avec le substrat cible 22 soit par sa face avant 10, soit par sa face arrière 8.

L'invention permet d'obtenir finalement, une structure avec une couche mince sur un substrat où la couche mince et le substrat peuvent avoir des coefficients de dilatation thermique différents, en s'affranchissant, grâce à l'invention, des contraintes de dilatation thermique différentielles et d'obtenir des couches minces de bonne qualité.

## Revendications

1. Procédé de fabrication d'une structure comportant une couche mince semi-conductrice (4) adhérente sur un substrat (24) dit substrat cible, caractérisé en ce qu'il comporte les étapes suivantes :
a) - fabrication d'une première structure comportant une couche mince semi-conductrice sur un premier substrat (2), la couche mince présentant une première face libre (10) dite face avant et une seconde face (8) dite face arrière liée au premier substrat par une première énergie de liaison Eₒ,
b) - transfert de la couche mince (4) du premier substrat (2) sur le substrat cible (24), ce transfert comportant à la fois un arrachement de la couche mince (4) du premier substrat (2) par l'application sur l'ensemble couche mince/premier substrat de forces d'arrachement aptes à vaincre la première énergie de liaison Eₒ, et une mise en contact adhérent de la couche mince (4) sur le substrat cible (24).

2. Procédé selon la revendication 1, caractérisé en ce que l'étape b) comporte :
b₁) - la mise en contact adhérent d'un manipulateur (12) avec la première face (10) de la couche mince (4), le contact adhérent étant établi avec une seconde énergie de liaison E₁ supérieure à la première énergie de liaison Eₒ,
b₂) - séparation de la couche mince (4) et du premier substrat (2) par l'arrachement de la couche mince (4) au niveau de la seconde face (8) et du premier substrat,
b₃) - mise en contact adhérent de la seconde face de la couche mince (4) sur le substrat cible avec une troisième énergie de liaison E₂, et séparation de la couche mince (4) du manipulateur.

3. Procédé selon la revendication 2, caractérisé en ce que la troisième énergie de liaison E₂ est supérieure à la seconde énergie de liaison E₁.

4. Procédé selon la revendication 1, caractérisé en ce que l'étape b) comporte successivement la mise en contact adhérent directement de la première face (10) de la couche mince (4) sur le substrat cible (24) avec une énergie de liaison supérieure à la première énergie de liaison, puis l'arrachement de la couche mince (4), du premier substrat (2).

5. Procédé selon la revendication 1, caractérisé en ce que le premier substrat (2) présente un coefficient de dilatation sensiblement identique au coefficient de dilatation de la couche mince.

6. Procédé selon l'une quelconque des revendications 1 à 3, caractérisé en ce que les forces d'arrachement comprennent une force de traction et/ou une force de cisaillement.

7. Procédé selon la revendications 1, caractérisé en ce que la couche mince sur le premier substrat est obtenue par :
- une implantation d'ions de gaz rare ou d'hydrogène dans un substrat supplémentaire à travers sa surface pour générer une couche de microbulles gazeuses s'étendant sensiblement selon un plan qui délimite dans le substrat supplémentaire une couche mince superficielle,
- la mise en contact adhérent de la couche mince et du premier substrat avec la première énergie de liaison,
- un traitement thermique qui par un effet de réarrangement cristallin et par un effet de pression dans les microbulles gazeuses provoque un clivage séparant la couche mince du reste du substrat supplémentaire.

8. Procédé selon la revendication 2, caractérisé en ce que lors de l'étape b₃), la séparation de la couche mince (4) et du manipulateur a lieu postérieurement à la mise en contact adhérent de la couche mince (4) avec le substrat cible (24).

9. Procédé selon la revendication 2, caractérisé en ce que lors de l'étape b₃), la séparation de la couche mince (4) et du manipulateur a lieu antérieurement à la mise en contact adhérent de la couche mince (4) et du substrat cible (24).

10. Procédé selon la revendication 9, caractérisé en ce que lors de l'étape b₃), le manipulateur et la couche mince sont plongés dans un bain chimique pour dissoudre le manipulateur, la couche mince étant recueillie sur le substrat cible.

11. Procédé selon la revendication 9, caractérisé en ce que lors de l'étape b₃), la couche mince (4)est mise en contact adhérent avec le substrat cible (24) par sa première ou seconde face.

12. Procédé selon la revendication 2, caractérisé en ce que lors de l'étape b₁), le contact adhérent entre le manipulateur (12) et la couche mince (4) est réalisé par des forces électrostatiques et lors de l'étape b₃), la séparation de la couche mince (4) et du manipulateur (12) est obtenue par suppression desdites forces électrostatiques.

13. Procédé selon l'une quelconque des revendications 1 à 12, caractérisé en ce que le contact adhérent est obtenu par un traitement thermique et/ou de pression et/ou de préparation chimique des surfaces à mettre en contact.

14. Procédé selon l'une quelconque des revendications 2 à 13, caractérisé en ce qu'on réalise le contact adhérent entre la couche mince et le manipulateur, avec un adhésif.

15. Procédé selon l'une des revendications 1 à 14, caractérisé en ce que le substrat cible présente une surface de mise en contact supérieure à la surface de l'une des première et seconde faces de la couche mince.

16. Procédé selon l'une quelconque des revendications précédentes, caractérisé en ce que la couche mince (4) est une couche de matériau semi-conducteur monocristallin.
